# EUROPEAN PATENT APPLICATION

(11) **EP 0 858 101 A2**
(43) Date of publication of application: **12.08.1998**
(21) Application number: 98102117.3
(22) Date of filing: 06.02.1998
(51) Int. Cl.: H01L 21/205

(54) **Manufacturing of an Si/SiGe super lattice structure by epitaxial growth**

(30) Priority: 06.02.1997 JP 23606/97
(71) Applicant: NEC CORPORATION, Tokyo (JP)
(72) Inventor: Aoyama, Tohru, Minato-ku, Tokyo (JP)
(74) Representative: Glawe, Delfs, Moll & Partner

(57) **Abstract**

The selective growth of a semiconductor film is disclosed while preventing concentrations at the time of a growth of a SiGe epitaxial layer to form a SiGe layer free from defects. In a UHV-CVD apparatus, after a substrate for growth is fitted, a substrate temperature is set to 650 °C, disilane is irradiated onto a surface of the substrate, and the irradiation is finished before Si clusters are formed on an oxide film. Chlorine is irradiated, thereby removing Si atoms on the oxide film. These steps are repeatedly performed, thereby forming a Si epitaxial layer. The substrate temperature is lowered to 550 °C, irradiation of disilane and germane and irradiation of chlorine are repeatedly performed, thereby forming a SiGe epitaxial layer. While keeping the substrate temperature at 550 °C, disilane is irradiated, thereby forming Si cover layer. The substrate temperature is elevated to 650 °C and the a Si epitaxial layer is formed by the same steps as those for the formation of the former Si epitaxial layer. The epitaxial step is repeatedly performed similarly, thereby forming a Si/SiGe super lattice structure.

## Description

### Background of the Invention

The present invention relates to a method of manufacturing a semiconductor device and, more particularly, to a method for selectively growing a silicon film or a film containing silicon and germaneium on a substrate by using an epitaxial growth technique.

A selective epitaxial growth is used for growing a semiconductor film on a surface of a single crystal substrate portion defined by an opening of an insulating film formed on the substrate. It has been reported that the epitaxial growth of the silicon film containing silicon and germanium is achieved by a method to supply etching gas as well as gas for a growth and by a method to alternately perform a growth step for supplying only the gas for a growth and an etching step for supply only etching gas.

In Japanese Laid-Open Patent Publication Hei 4-139819, such a method has been proposed that a growth step and an etching step are alternately repeated whereby a silicon epitaxial layer or a silicon layer containing germanium is selectively grown. Specifically, a silicon substrate partially covered with a silicon oxide film is fitted into an ultra high vacuum chemical vapor deposition ( UHV-CVD ) apparatus of a maximum attainable vacuum of 1 × 10⁻⁹ Torr, a temperature of the substrate is kept at 700 °C and irradiation of di-silane ( Si₂H₆ ) for 60 sec. and irradiation of chlorine gas are alternately performed, thereby selectively growing a silicon epitaxial layer. According to the above-described method, di-silane and germane ( GeH₄ ) are simultaneously supplied, whereby a silicon layer containing germanium can be selectively grown according to a similar method.

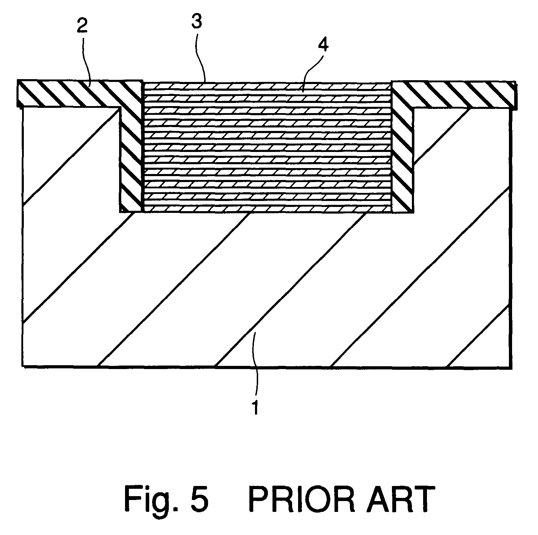

Next, a manufacture of a light receiving device for 1.3 µm band using the selective epitaxial growth method recited in the foregoing gazette will be described. A sectional structure of a light receiving portion of the light receiving device for 1.3 µm band is shown in Fig. 5. The light receiving portion thereof has a super lattice structure that a silicon epitaxial layer 3 and a silicon epitaxial layer 4 containing germanium are alternately stacked upon another. The reason why the super lattice structure is adopted in the light receiving portion of the light receiving device is that a distortion is relaxed by interposing the silicon epitaxial layer 3 therebetween in order that no defects are created in the super lattice. A concentration of germanium in the silicon epitaxial layer containing germanium suitable for 1.3 µm band is 50 %.

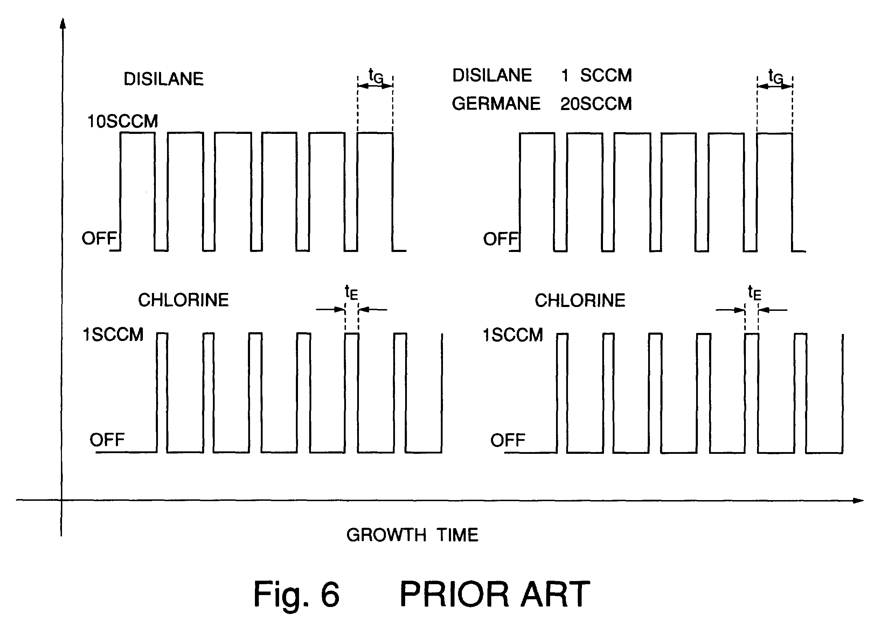

A side surface of the device and an upper surface of a single crystal silicon substrate 1 are covered with a silicon oxide film 2, and the light receiving portion is selectively grown in an opening portion according to a processing sequence as shown in Fig. 6. A temperature of the substrate 1 is set to 700 °C, and disilane of 10 SCCM is irradiated for 60 sec. during the growth step of the silicon epitaxial layer 3 and chlorine of 1 SCCM is irradiated for 15 sec. during the etching step. Moreover, disilane of 1 SCCM and germane of 20 SCCM are irradiated for 60 sec. during the growth step of the silicon epitaxial layer 4 containing germanium, and chlorine of 1 SCCM is irradiated for 15 sec. during the etching step. Thus, the super lattice structure of a total thickness of 2.3 µm is selectively formed, which is constituted by alternatively stacking the silicon epitaxial layer of 2000 Å and the silicon epitaxial layer of 100 Å containing germanium upon another by 10 cycles.

In the above described conventional method, the etching step is performed by stopping the growth step immediately before it becomes impossible to maintain the selective growth for the continuous growth. For this reason, when the etching step is begun, silicon has been already grown on the silicon oxide film in a cluster shape so that in order to etch with a chlorine irradiation etching must be performed at a high temperature of about 700 °C or more. It becomes difficult to remove the silicon on the silicon oxide film perfectly below 700 °C. The thickness of the silicon epitaxial layer which is to be selectively grown reduces and the thickness thereof is at most about 1000 Å at a temperature of 650 °C.

Since the silicon epitaxial layer containing germanium inherently involves distortions, condensations occur when it is grown at a high temperature. Defects are disadvantageously created in the film. A temperature when the defects are created differs depending on a germanium concentration in the silicon epitaxial layer containing germanium. In case of a silicon super lattice containing germanium for a 1.3 µm band light receiving device, the germanium concentration is 50 %, and when a growth temperature is made above 550 °C, the defects occur. Moreover, when it is exposed to a temperature as high as 700 °C after the epitaxial growth, the concentrations also occur so that the defects are created.

Therefore, when the 1.3 µm band light receiving portion is formed by the conventional selective growth method, defects are created in the silicon epitaxial layer 4 containing germanium. Therefore, a quantum efficiency of the light receiving device is as low as about 1 % so that a light receiving device of a high performance can not be provided.

### Summary of the Invention

The object of the present invention is to provide a manufacturing method of a semiconductor device which is capable of obtaining a selective growth silicon epitaxial layer of a sufficient thickness even at a growth temperature below 700 °C.

Another object of the present invention is to provide a manufacturing method of a semiconductor device which is capable of growing a silicon epitaxial layer containing germanium in a super lattice structure without creating defects therein.

A method of manufacturing a semiconductor device of the present invention employs a selective growth in which a growth step and an etching step are repeated, but a period of the growth step in one cycle is made shorter than in the conventional method. In the conventional method, the growth step is completed immediately before selectivity is destroyed, that is, immediately before a growth of polycrystalline silicon on a silicon oxide film starts. In the manufacturing method of a semiconductor device of the present invention, the growth step is completed before a silicon film containing silicon or germanium is grown on the silicon oxide film in a cluster shape. The period until the silicon film containing silicon or germanium is grown on the silicon oxide film is approximately 1/3 of a period until these films start to grow as a polycrystalline film.

Moreover, when a silicon super lattice structure of a light receiving portion containing silicon/germanium is manufactured, a growth temperature of a silicon epitaxial layer containing germanium is set to a temperature so that no concentrations occur in this epitaxial layer. Specifically, the growth temperature of the silicon epitaxial layer containing germanium is set to be 600 °C or less. In addition, also in formation step of the silicon epitaxial layer containing germanium, the growth step is stopped before germanium or silicon is grown in a cluster shape, and etching is performed. Then, the layer is stacked alternatively upon the silicon epitaxial layer which is grown under the above described conditions, thereby completing the super lattice structure of the present invention.

When this super lattice structure is manufactured, the growth of the silicon epitaxial layer is conducted under the following conditions.
( 1 ) The growth of the silicon epitaxial layer is performed at a temperature of 600 °C or more which is higher than that of the growth temperature of the silicon epitaxial layer containing germanium. After the growth of the silicon epitaxial layer containing germanium, silicon cover layers should preferably be grown by several atom layers while keeping the temperature to that of the growth of this silicon epitaxial layer when it is grown, and, after that, the temperature is increased to 600 °C or more, thereby growing the silicon epitaxial layer.
( 2 ) Alternately, the silicon epitaxial layer and the silicon epitaxial layer containing germanium are formed at the same growth temperature, and ultra violet radiation is performed after completion of the etching step, in order to promote a reaction and to remove chloride and chlorine.

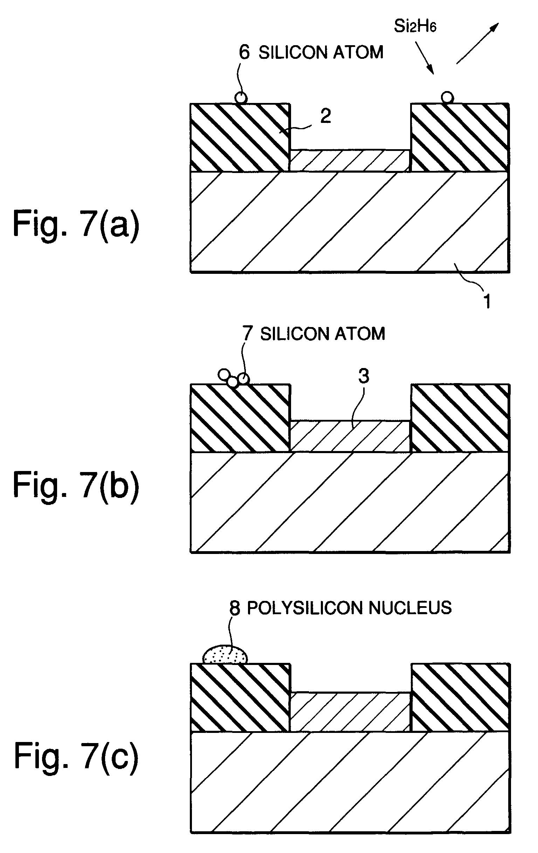

Discribing in more detail the technical operation of the present invention, states of segregation of the silicon on the silicon oxide film 2 provided on the single crystal silicon substrate 1 are shown in Figs. 7( a ), 7( b ) and 7( c ). Disilane is decomposed and silicon atoms 6 attach to the silicon oxide film 2, although they attach thereto frequently less than to the single crystal silicon substrate 1 ( Fig. 7 ( a )) . As time goes by, their densities increase so that silicon clusters 7 are formed ( Fig. 7( b )). Thereafter, a poly silicon nucleus 8 is formed, thereby destroying selectivity ( Fig. 7( c )). The conventional method is the one in which an etching step is performed for the selective growth before the growth of the poly silicon nucleus 8. The etching is possible only at a temperature of 700 °C or more after the silicon atoms 6 have once formed the silicon clusters 7. However, in the state where a single atom 6 attaches to the silicon oxide film 2 as shown in Fig. 7( a ), it is possible to perform removal from the silicon oxide film 2 by combining with chlorine even at a temperature of 700 °C or less where no silicon etching occurs. For this reason, by shortening the period of the growth step in one cycle, selectivity of the epitaxial growth can be increased.

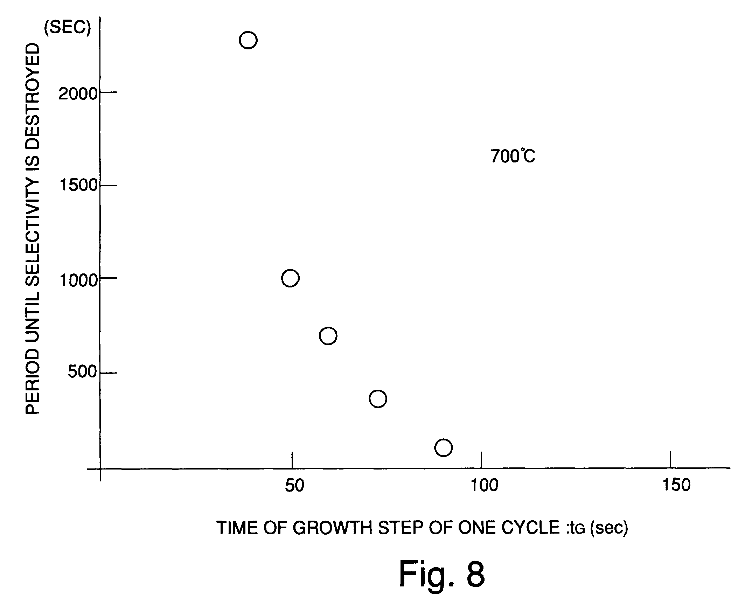

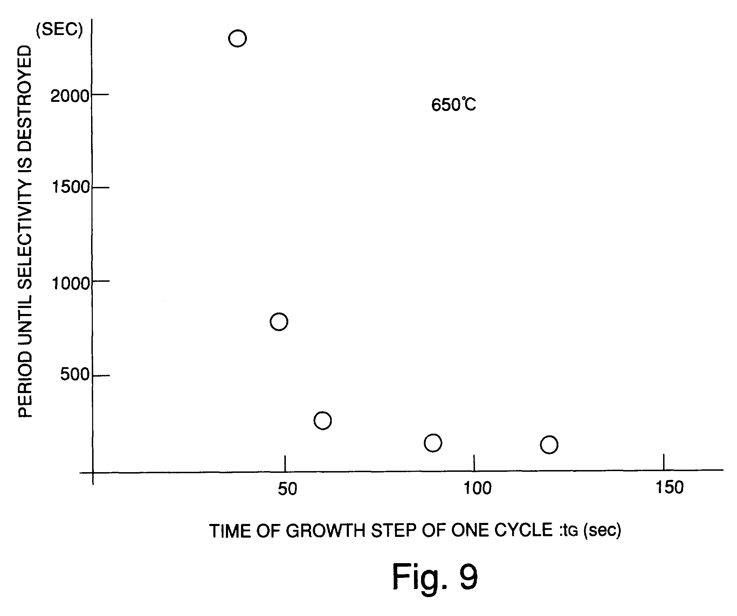

Fig. 8 is a graph showing a relation between a growth time t_{G} in one cycle and an accumulation growth time, when the substrate temperature is set to 700 °C, disilane of 10 SCCM is supplied in the growth step while changing the growth time t_{G} in one cycle, and chlorine of 1 SCCM is irradiated for 15 seconds of the etching time t_{E} in the etching step. Moreover, Fig. 9 is a graph showing a relation between the growth time t_{G} in one cycle and the accumulation growth time until the selective growth is destroyed, when the substrate temperature is set to 650 °C and other conditions are the same as the case of Fig. 8.

It is proved that under the condition of the substrate temperature of 700 °C, the selectivity is destroyed after 90 seconds. As the time of the growth step is made shorter, the accumulation time when the selective growth can be performed is prolonged. The accumulation time is significantly prolonged after passage of 40 seconds. This implies that because the silicon atoms on the silicon oxide film forms no clusters before the passage of 40 seconds the silicon atoms are easily etched, and the silicon atoms are not liable to be etched after formation of the clusters. Then, when the growth time in one cycle is shortened to 30 seconds, a semi-permanent selective growth can be performed.

This tendency becomes more remarkable at a growth temperature of 650 °C. Under the condition of the substrate temperature of 650 °C, the selectivity is destroyed after passage of 120 seconds. Unlike the condition of the substrate temperature of 700 °C, the accumulation time wherein the selective growth can be performed is not prolonged so much even when the growth step time is shortened. However, the accumulation time when the selective growth can be performed is significantly prolonged after the passage of 60 seconds, and the selective growth can be performed semi-permanently. From such fact, it is founded that after the formation of the clusters, the silicon atoms can not be etched at the substrate temperature of 650 °C and the silicon atoms can be etched at the substrate temperature of 650 °C before the silicon atoms form the clusters. The clusters are not formed for 1/3 of at least the time when the selectivity is destroyed. It is found that if etching is performed for that period, the selectivity is increased rapidly.

Moreover, when the silicon super lattice structure of the light receiving portion containing silicon/germanium is manufactured, the epitaxial growth is performed at a growth temperature of 600 °C or less so as not to create defects in the silicon epitaxial layer containing germanium. In such case, a problem of detachment of chlorine atoms absorbed on the surface of the epitaxial layer after completion of the etching step is produced. Since germanium atoms have a function to promote detachment of the chlorine atoms absorbed on the epitaxial layer, the chlorine atoms on the silicon epitaxial layer 4 containing 50 % germanium can be detached even below 600 °C. However, in order to detach the chlorine atoms on the silicon epitaxial layer, a temperature of 600 °C or more is necessary.

In the first aspect of the present invention, the silicon epitaxial layer containing germanium is grown. Before the temperature is elevated, the silicon cover layer is grown by several atom layers. The reason why such processes are adopted is to prevent the creation of the defects on the silicon epitaxial layer containing germanium even when the temperature is elevated to 600 °C or more. This is for preventing the germanium atoms from being exposed on the upper most of the surface by growing the silicon layer thin. Thus, the diffusion of the germanium atoms on the surface can be controlled, and condensations of the silicon epitaxial layer containing germanium due to an increase in a temperature can be suppressed. Moreover, deterioration of flatness of the silicon epitaxial layer containing germanium due to an elevation of a temperature and the occurrence of the defects can be prevented.

Moreover, in the second aspect of the present invention, the growth of the silicon epitaxial layer is performed at a temperature of 600 °C or less, and an ultra violet irradiation step is performed after the etching step, whereby the chlorine atoms absorbed on the silicon surface can be detached. Furthermore, a reaction of the silicon atoms on the silicon oxide film is promoted by the ultra violet irradiation, whereby the removal of them is feasible even at a low temperature. Moreover, if the ultra violet irradiation is performed also at the time of the growth of the silicon epitaxial layer containing germanium, the removal of the chlorine atoms on the surface of the silicon epitaxial layer containing germanium can be realized with a more security.

As described above, the occurrence of the defects in both of the silicon epitaxial layer containing germanium and the silicon epitaxial layer can be prevented, whereby the silicon super lattice structure containing silicon/germanium with a good quality can be realized. By applying this super lattice structure to the light receiving device, a light receiving device with a high quantum efficiency can be realized.

### Brief Description of the Drawings

For a more complete understanding of the present invention and the advantages thereof, reference is now made to the following description taken in conjunction with the accompanying drawings, in which;
Figs. 1( a ) and 1( b ) are sectional views showing growth steps of a substrate, for explaining a first embodiment of the present invention;
Fig. 2 is a view showing a processing sequence for explaining the first embodiment and a first example;
Figs. 3( a ) to 3( f ) are sectional views showing growing steps of a substrate, for explaining a second embodiment and a second example;
Fig. 4 is a view showing a processing sequence for explaining a third embodiment and a third example of the present invention;
Fig. 5 is a sectional view of a light receiving portion of a light receiving device;
Fig. 6 is a view showing a conventional processing sequence for manufacturing a super lattice structure composed of a silicon epitaxial layer and a silicon epitaxial layer containing germanium;
Fig. 7 is a sectional view illustrative of an operation of this invention; and
Fig. 8 and 9 are graphs illustrative of an operation of this invention.

### Detailed Description of the Preferred Embodiments

Embodiments of the present invention will be described with reference to the accompanying drawings below.

### [ First Embodiment ]

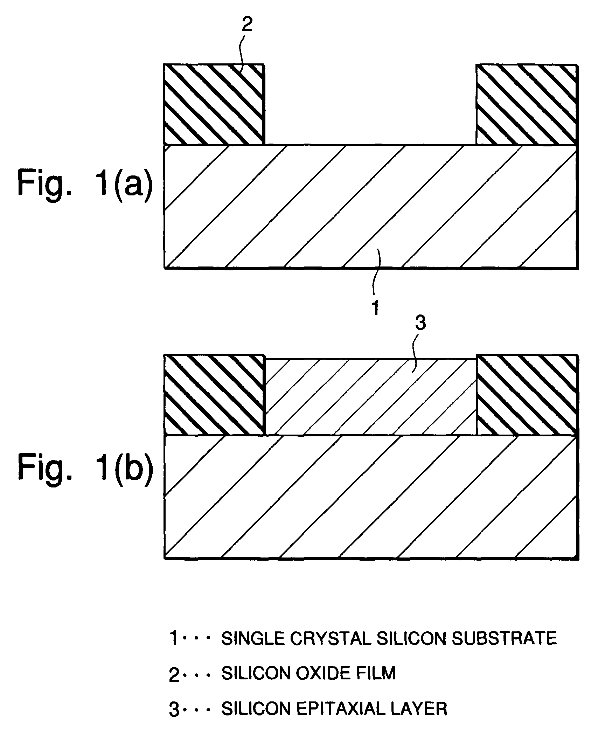

In the first embodiment, the substrate to be grown is covered with a silicon oxide film 2 as shown in Fig. 1( a ), and the single crystal silicon substrate 1 is exposed on the bottom portion of its opening.

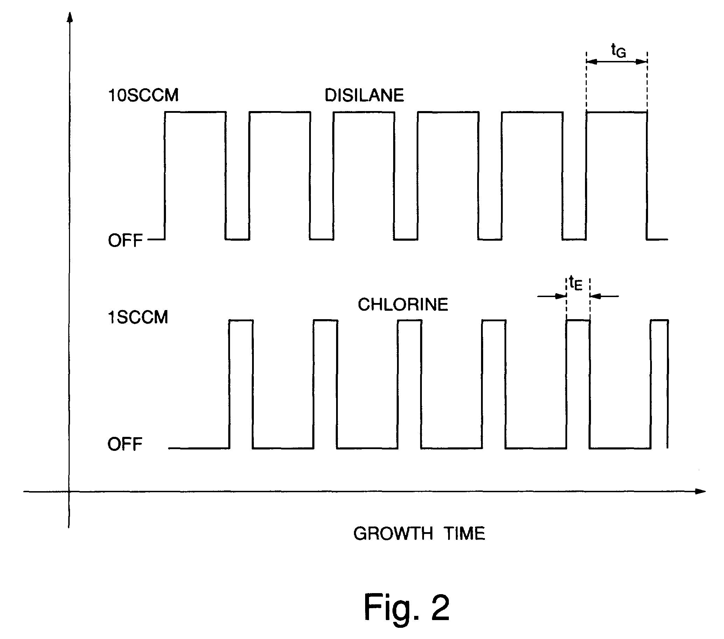

The selective epitaxial growth is performed by a method to repeat a growth step and an etching step according to a processing sequence shown in Fig. 2. A temperature of the substrate is set to be 600 °C or more, for example, 650 °C. Silane or disilane is irradiated in the growth step onto the substrate. In the etching step, chlorine, hydrogen chloride or chlorine radical is irradiated, thereby forming the silicon epitaxial layer 3 as shown in Fig. 1( b ).

The growth time tG is completed before silicon clusters are formed on the silicon oxide film. The growth time tG is 1/3 of the time until the selectivity is destroyed when the epitaxial growth is almost continuously performed.

This embodiment can be modified as follows. The substrate temperature is set to 600 °C or less, for example, 550 °C. After completion of the etching step, ultra violet ray is irradiated onto the surface of the substrate. Thus, after a temperature of the substrate is lowered to be low, silicon on the silicon oxide film and chlorine on the epitaxial layer can be removed.

### [ Second Embodiment ]

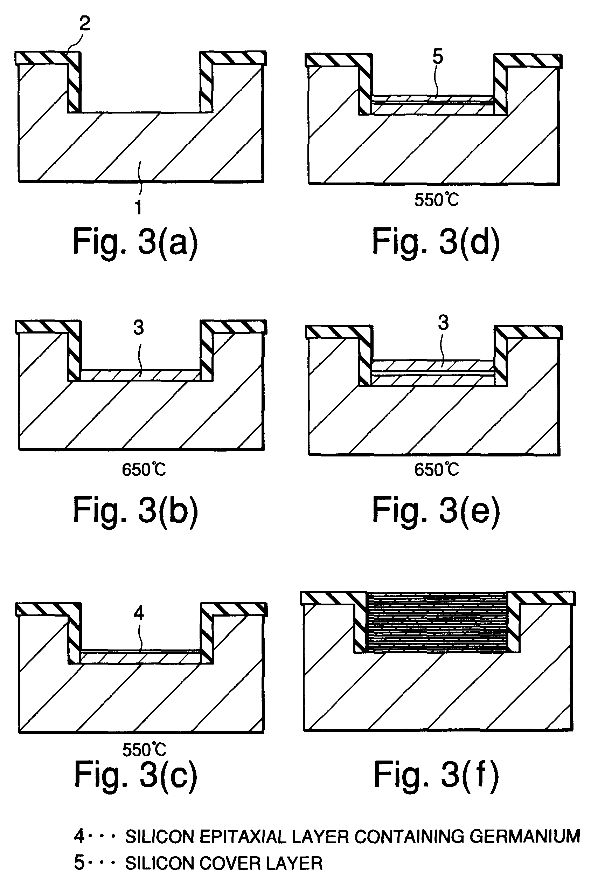

The second embodiment relates to a formation method of a light receiving portion of a light receiving device. The surface and side surface of the grown substrate of the light receiving portion are covered with the silicon oxide film 2 as shown in Fig. 3( a ). The single crystal substrate 1 is exposed in the bottom of its opening. First, the substrate temperature is set to 600 °C or more, for example, 650 °C. The growth step for irradiating disilane or silane and the etching step for irradiating chlorine, hydrogen chloride or chlorine radical are performed repeatedly, thereby selectively forming the silicon epitaxial layer 3 as shown in Fig. 3( b ).

Thereafter, the temperature is lowered to 600 °C or less, for example, 550 °C , at which no concentrations in the silicon epitaxial layer containing germanium occur. The growth step for irradiating disilane or silane, and germane or di-germane and the etching step are performed repeatedly, thereby forming the silicon epitaxial layer 4 as shown in Fig. 3( c ). Since germanium atoms on the surface of the substrate help the detachment of chlorine absorbed, the silicon epitaxial layer 4 containing germanium has an ability to detach chlorine atoms even at a temperature of 600 °C or less.

Next, while keeping the temperature of the substrate at the time of formation of the silicon epitaxial layer containing germanium invariable, disilane or silane is irradiated, thereby epitaxially growing the silicon cover layer 5 on the silicon epitaxial layer 4 containing germanium as shown in Fig. 3( d ). Then, before or after the etching step, the growth temperature is elevated to 600 °C or more, for example, 650 °C, thereby forming the silicon epitaxial layer 3 as shown in Fig. 3( e ).

The foregoing epitaxial growth is repeated a plurality of times, for example, ten times, thereby manufacturing the silicon super lattice structure containing silicon/germanium of a predetermined thickness as shown in Fig. 3( f ).

### [ Third Embodiment ]

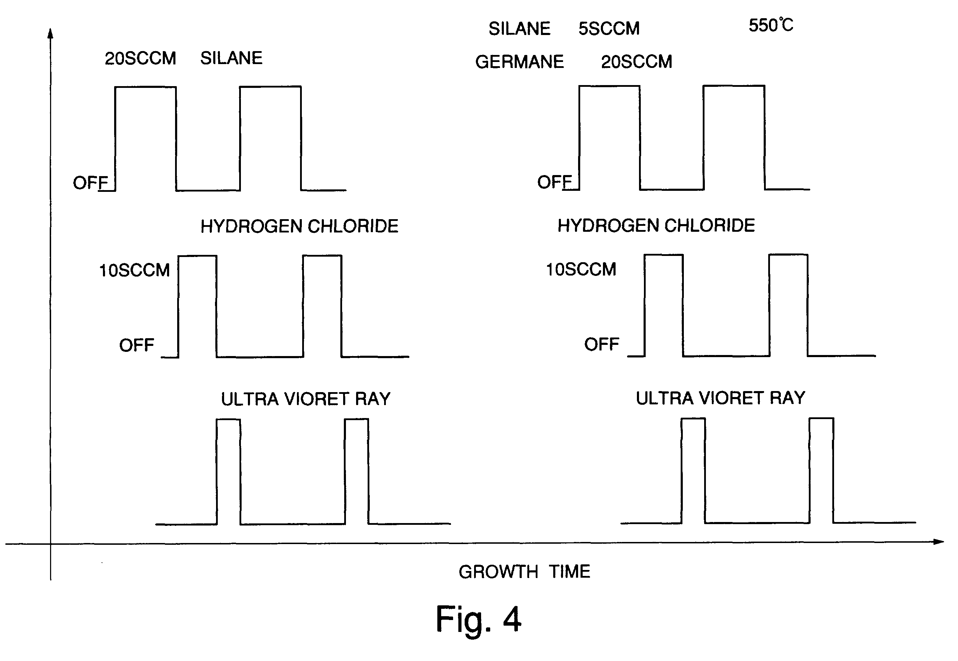

Also the third embodiment relates to a formation method of the super lattice structure composed of the silicon epitaxial layer containing silicon/germanium. In this embodiment, the light receiving portion is formed by repeatedly performing a growth step, an etching step and an ultra violet irradiation step according to a growth sequence shown in Fig. 4, thereby forming a light receiving portion.

First, a silicon epitaxial layer is selectively grown at the same temperature as a growth temperature ( 600 °C or less, for example, 550 °C ) for forming a silicon epitaxial layer containing germanium. In the growth step, silane or disilane is irradiated, and in the etching step chlorine, hydrogen chloride or chlorine radical is irradiated. In this embodiment, since no chlorine attached to a silicon surface detaches therefrom at a low temperature, after the etching step for irradiating etchant ultra violet ray is irradiated, thereby chlorine atoms on the silicon epitaxial layer are detached. For the ultra violet ray irradiation, a mercury lamp of a wavelength 2540 Å close to combination energy of Si-Cl can be used.

Thereafter, at the growth temperature of 600 °C or less, for example, 550 °C, the growth temperature for irradiating germane or di-germane, the etching step for irradiating chlorine, hydrogen chloride or chlorine radical and the ultra violet ray irradiation are repeatedly performed, thereby forming the silicon epitaxial layer containing germanium.

The above described epitaxial growth is repeatedly performed a plurality of times, so that a silicon super lattice structure containing silicon/germanium of a predetermined thickness is manufactured.

### Example

Next, examples of the present invention will be described with reference to the accompanying drawings.

### [ First Example ]

In this example, an UHV-CVD apparatus which is capable of exhausting the air to an ultra high vacuum of 1 × 10⁻⁹ Torr was used, thereby growing the silicon epitaxial layer 3 on the growth substrate shown in Fig. 1( a ), as shown in Fig. 1( b ). The selective epitaxial growth was conducted at the growth temperature of 650 °C. In the growth temperature, the growth time t_{G} was 40 seconds and disilane of 10 SCCM was irradiated. In the etching step, the etching time t_{E} was 15 seconds and chlorine of 1 SCCM was irradiated.

By repeatedly performing the growth step and the etching step, the silicon epitaxial layer 3 can be selectively grown to a thickness of at least 3 µm. This silicon epitaxial layer has the thickness more than 30 times compared to that of 1000 Å grown by the conventional method.

### [ Second Example ]

The substrate used for the growth shown in Fig. 3( a ) was fitted to the UHV-CVD apparatus which is the same as that of the first example. The substrate temperature was set to 650 °C, and the growth step and the etching step were repeatedly performed, thereby selectively growing the silicon epitaxial layer 3 to a thickness of 2000 Å ( Fig. 3( b )). In the growth step, disilane of 10 SCCM was irradiated. In the etching step, chlorine of 1 SCCM was irradiated.

Thereafter, the substrate temperature is lowered to 550 °C, and the silicon epitaxial layer 4 containing germanium of concentration 50 % was grown to a thickness of 100 Å by repeating the growth step and the etching step ( Fig. 3( c )). In the growth step, disilane of 1 SCCM and germane of 20 SCCM were irradiated for 30 seconds, and in the etching step chlorine of 1 SCCM was irradiated for 15 seconds. Since the germanium atoms on the surface help to detachment of chlorine absorbed, the silicon epitaxial layer 4 containing germanium could detach the chlorine atoms even at 550 °C.

Next, while keeping the substrate temperature at 550 °C, disilane of 5 SCCM was irradiated for 60 seconds, thereby epitaxially growing the silicon cover layer 5 on the silicon epitaxial layer 4 containing germanium ( Fig. 3( d )). Then, the substrate temperature was elevated to 650 °C, and chlorine of 1 SCCM was irradiated for 20 seconds, thereby performing etching. Thereafter, the next silicon epitaxial layer 3 was formed to a thickness of 2000 Å ( Fig. 3( e )).

The above described epitaxial growth was repeated ten times, and the silicon super lattice structure containing silicon/germanium free from defects having a thickness of 2.3 µm could be formed ( Fig. 3 ( f )).

A quantum efficiency of the light receiving device formed by this embodiment is 10 %, resulting in a remarkable improvement of that of the conventional light receiving device of 1 %.

### [ Third Embodiment ]

Also in this embodiment, the same growth apparatus and the same substrate for the growth as the first embodiment were used. According to the processing sequence shown in Fig. 4, the substrate temperature was set to 550 °C and the silicon epitaxial layer was first formed to a thickness of 2000 Å. In the growth step, silane of 20 SCCM was irradiated for 40 seconds. In the etching step, hydrogen chloride of 10 SCCM was irradiated for 30 seconds. After completion of the etching step, using the mercury lamp ultra violet ray of a wavelength 2540 Å was irradiated for 15 seconds, whereby detaching chlorine atoms on the silicon epitaxial layer.

Thereafter, while keeping the substrate temperature at 550 °C, the silicon epitaxial layer containing germanium of germanium concentration 50 % was grown to a thickness of 100 Å by repeatedly performing the growth step, the etching step and the ultra violet ray irradiation step. In the growth step, silane of 5 SCCM and germane of 20 SCCM were irradiated for 40 seconds. In the etching step, hydrogen chloride of 10 SCCM was irradiated for 30 seconds. Thereafter, ultra violet ray irradiation was performed for 15 seconds, whereby chlorine was removed fully from the surface.

The above described epitaxial growth was repeated ten times, and the silicon super lattice structure containing silicon/germanium free from defects having a thickness of 2.3 µm could be formed. Also in this embodiment, a quantum efficiency of the light receiving device is 10 %, and it was proved that the quantum efficiency can be enhanced by ten times that of the conventional light receiving device of 1 %.

As described above, according to the manufacturing method of the present invention, in the epitaxial growth in which the growth step and the etching step are alternatively performed, the growth step is completed before the growth material is grown on the insulating film in a cluster shape, whereby the thickness of the epitaxial layer susceptible to be selectively grown can be remarkably increased. Moreover, in the manufacturing method of the present invention, the epitaxial growth of the silicon layer containing germanium is performed at a low temperature in which no concentrations occur in this epitaxial silicon layer. Therefore, the silicon layer containing germanium can be formed as a layer free from defects and the selective growth of the silicon super lattice structure containing silicon/germanium free from defects can be realized, resulting in a significant increase in the quantum efficiency of the light receiving device.

## Claims

1. A mehod of manufacturing a semiconductor device comprising:
selectively forming a super lattice structure on a single crystal silicon partially covered with an insulating film, the super lattice structure being constituted by one of stacking a silicon epitaxial layer upon another and alternatively stacking a silicon epitaxial layer and a silicon epitaxial layer containing germanium,
wherein the epitaxial layer is formed by alternatively performing a growth step for irradiating growth material gas and an etching step for irradiating gas containing chlorine, and a period for the growth step is set to 1/3 or less of a period which is necessary to destroy selectivity in case where the growth step is continuously performed.

2. The manufacturing method according to claim 1, wherein said silicon epitaxial layer is formed at a growth temperature of 600 °C or more, except for a portion formed directly above the silicon epitaxial layer containing germanium.

3. The manufacturing method according to claim 1, wherein the silicon epitaxial layer containing germanium is formed at a growth temperature in which no concentrations occur therein.

4. The manufacturing method according to claim 1, wherein after the silicon epitaxial layer containing germanium is formed at a temperature of 600 °C or less, a thin silicon epitaxial layer is formed while keeping the temperature for formation of the silicon epitaxial layer containing germanium, and then the silicon epitaxial layer is formed after elevating the temperature to 600 °C or above.

5. The manufacturing method according to claim 1, wherein chlorine molecules, hydrogen chloride molecules or chlorine radicals is irradiated onto the substrate in the etching step.

6. The manufacturing method according to claim 1, wherein the silicon epitaxial layer and the silicon epitaxial layer containing germanium are formed at the same growth temperature, and in a formation step of the silicon epitaxial layer, at least ultra violet ray is irradiated onto a surface of the substrate before starting the growth step after completion of the etching step.
